# EUROPEAN PATENT APPLICATION

(11) **EP 2 086 004 A1**
(43) Date of publication of application: **05.08.2009**
(21) Application number: 07828067.4
(22) Date of filing: 22.11.2007
(51) Int. Cl.: H01L 21/673, B65D 81/24, B65D 85/86

(54) **MEMBER ARRANGED IN WAFER STORING CONTAINER AND METHOD FOR MANUFACTURING THE MEMBER**

(30) Priority: 24.11.2006 JP 2006317309
(71) Applicant: Sumitomo Electric Industries, Ltd., Osaka-shi, Osaka 541-0041 (JP)
(72) Inventor: OHAMA, Osamu, Osaka-shi Osaka 554-0024 (JP); YAMAZAKI, Noboru, Osaka-shi Osaka 554-0024 (JP)
(74) Representative: Grünecker, Kinkeldey, Stockmair & Schwanhäusser Anwaltssozietät
(86) International application number: PCT/JP2007/001290
(87) International publication number: WO 2008/062564

(57) **Abstract**

A high-quality member installed in a wafer storage case is provided in which the wafer is not contaminated by the generated sulfur gas and the injection molding process is satisfactorily carried out.

A member 1 installed in a case 2 for storing a wafer 3 is formed by injection molding a polybutylene terephthalate (PBT) resin. The PBT resin has a weight-average molecular weight (Mw) of 15000 to 20000. The member 1 installed in the wafer storage case is formed by injection molding so that the weight of sulfur in a sulfur-containing secondary antioxidant added to the PBT resin is 0.1% or less of the weight of the PBT resin.

## Description

### Technical Field

The present invention relates to a member installed in a case for storing a semiconductor wafer, in particular, to a wafer holding member. The present invention also relates to a method for producing a member installed in a case for storing a semiconductor wafer.

### Background Art

In general, in carrying a semiconductor wafer, the wafer is stored in a wafer storage case that supports and prevents damage on the wafer. An example of such a wafer storage case is described in Patent Document 1. The wafer storage case disclosed in Patent Document 1 has a case main body with a circular barrel and a partition that divides the barrel into an upper portion and a lower portion, a lid that covers an upper opening of the case main body, and a wafer holding member disposed at the inner side of the lid as the lid is being attached to the case main body. The wafer holding member is configured to hold down the peripheral portion of the wafer stored in the case main body toward the partition of the case main body.

The wafer storage case is formed by injection molding of a thermoplastic resin such as polypropylene, polyethylene, polycarbonate, or the like, for example.

The wafer holding member is also formed by injection molding of a thermoplastic resin such as polypropylene, polyethylene, polycarbonate, or the like. In particular, among thermoplastic resins, a polybutylene terephthalate resin having excellent elasticity is suitable for the wafer holding member.

[Patent Document 1] Japanese Unexamined Patent Application Publication No. 2006-56573

### Disclosure of Invention

### Problems to be Solved by the Invention

However, in forming the wafer holding member with the polybutylene terephthalate resin, a sulfur-containing secondary antioxidant is usually added as an antioxidant in addition to a primary antioxidant. This sulfur-containing secondary antioxidant is commonly added since it not only prevents deterioration of the resin but also improves the soundness of processes during injection molding.

However, it has been found that sulfur in the sulfur-containing antioxidant becomes decomposed during injection molding. Once a large quantity of sulfur gas is generated from the wafer holding member, the wafer in contact with the wafer holding member becomes contaminated with the sulfur gas, thereby incurring a problem of degraded quality.

Furthermore, the applicant of the present invention has studied the effect of sulfur gas on the wafer on the basis of the correlation between the sulfur gas concentration at the wafer surface and the photoluminescence (PL) intensity of the wafer.

**[Table I]**

| Sample No. | Surface S concentration (×E10 atoms/cm²) | PL intensity |
|---|---|---|
| Sample A | 53. 1 | 67. 1 |
| Sample B | 500. 0 | 20. 0 |
| Sample C | 136. 8 | 52. 6 |
| Sample D | 196. 2 | 50. 9 |
| Sample E | 404. 1 | 32. 1 |
| Sample F | 75. 8 | 69. 8 |
| Sample G | 85. 1 | 63. 6 |
| Sample H | 144. 4 | 59. 9 |

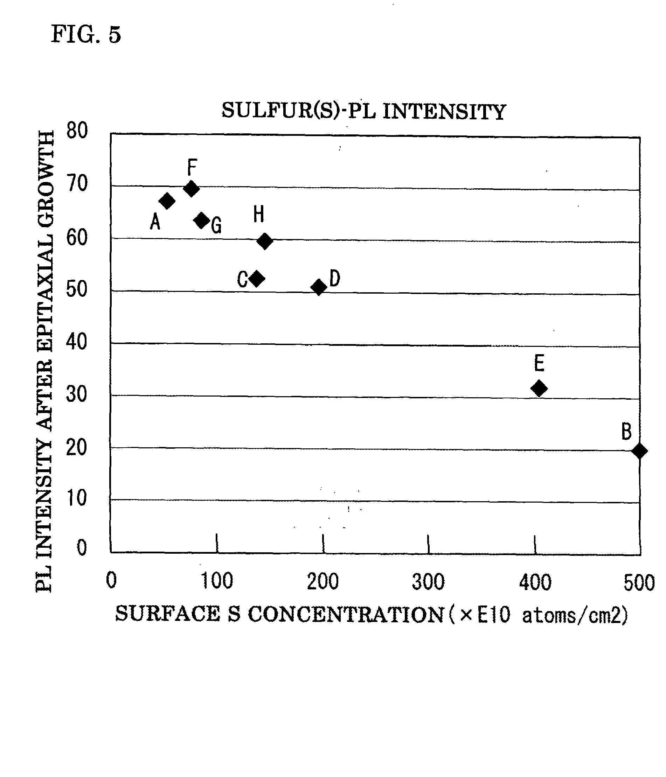

As shown in Samples A to H in Table I, the sulfur gas concentration (×E10 atoms/cm²) at the wafer surface was varied and the PL intensities of these samples were measured. The correlation is shown in the graph of Fig. 5. As a result, it has been found from the results shown in Table I and Fig. 5 that the sulfur gas concentration is preferably 200 (xE 10 atoms/cm²) or less since, in general, the quality of the wafer is maintained at a PL intensity of 50 or higher. The PL intensity is measured by using a wafer after forming an AlGaIn thin film on a gallium arsenide substrate.

As described above, the quantity of the sulfur gas generated inside the wafer storage case needs to be as small as possible to maintain the quality of the wafer inside the wafer storage case.

If the sulfur-containing antioxidant added to a PBT resin generates sulfur gas, it is possible to add a high activity catalyst to prevent contamination of the wafer by the gas; however, addition of the high activity catalyst increases the cost.

In view of the above, an object of the present invention is to provide a member installed in a wafer storage case in which contamination of the wafer by generation of sulfur gas is prevented, the process of injection molding is soundly carried out, and the wafer maintains good quality, and a method for producing the member.

### Means for Solving the Problems

A member installed in a case for storing a wafer is **characterized in that** the member in the case is formed by injection molding of a polybutylene terephthalate (PBT) resin; the weight-average molecular weight (Mw) of the PBT resin is 15000 to 20000; and the weight of sulfur in a sulfur-containing secondary antioxidant added to the PBT resin is 0.1% or less of the weight of the PBT resin.

The member installed in the case for storing the wafer of the present invention may be formed by adding a sulfur-containing secondary antioxidant in a weight more than 0% but not more than 0.1% to the PBT resin or by adding no sulfur-containing secondary antioxidant.

The resin viscosity during injection molding can be adjusted to a level suitable for injection molding without adding a sulfur-containing antioxidant since the weight-average molecular weight (Mw) of the PBT resin is at a relatively low level within the range of 15000 to 20000. Thus, the member installed in the wafer storage case can exhibit satisfactory quality. Therefore, good injection molded articles can be produced without substantial addition of the sulfur-containing antioxidant and generation of sulfur gas from the member can be nearly completely eliminated.

In the case where the weight-average molecular weight (Mw) of the PBT resin is lower than 15000, the molecular weight is excessively low, and this may decrease the mechanical strength of the molded article. In contrast, in the case where the weight-average molecular weight (Mw) is higher than 20000, the viscosity is excessively high and the soundness of the injection molding process is not satisfactory.

A method for producing a member installed in a case for storing a wafer according to the present invention is characterized by including injection molding a polybutylene terephthalate (PBT) resin having a weight-average molecular weight (Mw) of 15000 to 20000 so that the weight of sulfur in a sulfur-containing secondary antioxidant added to the PBT resin is 0.1% or less of the weight of the PBT resin.

According to the method of the present invention, as described above, the resin viscosity during injection molding can be adjusted to a level suitable for injection molding without adding a sulfur-containing antioxidant since the weight-average molecular weight (Mw) of the PBT resin is at a relatively low level within the range of 15000 to 20000. Thus, the workability is satisfactory. Therefore, injection molded can be performed satisfactorily without substantial addition of the sulfur-containing antioxidant and generation of sulfur gas from the member can be nearly completely eliminated.

In particular, the member installed in the wafer storage case is preferably injection molded at a molding temperature of 230°C to 265°C.

When the member is injection molded at such a temperature condition, the fluidity of the molten resin is satisfactory without addition of the sulfur-containing antioxidant, thereby leading to satisfactory working. Alternatively, trace amounts of the sulfur-containing antioxidant may be added since the quantity of the generated sulfur gas is also small and the problem of contamination of the wafer by generated sulfur gas does not arise.

At a molding temperature lower than 230°C, the surface smoothness of the molded article obtained by injection molding is degraded. At a temperature exceeding 265°C, organic volatile compounds derived from other additive agents become decomposed into gas, which is not preferred.

Examples of the member installed in the wafer storage case include a wafer holding member and a sealing member such as a packing. The member installed in the wafer storage case of the present invention is preferably applied to a wafer holding member that contacts the wafer. Since the wafer holding member is stored in the case together with the wafer, it is desired that the holding member emit as little sulfur gas as possible. The present invention can meet this need.

### Advantages

The resin viscosity during injection molding can be adjusted to a level suitable for injection molding without adding a sulfur-containing antioxidant since the weight-average molecular weight (Mw) of the PBT resin is at a relatively low level within the range of 15000 to 20000. Thus, the process can be soundly carried out and the member installed in the wafer storage case can exhibit satisfactory quality. Therefore, good injection molded articles can be produced without substantial addition of the sulfur-containing antioxidant and generation of sulfur gas from the member can be nearly completely eliminated.

### Brief Description of Drawings

[Figure 1] Figure 1 is s plan view of a wafer storage case having a wafer holding member, which is a member installed in the wafer storage case according to the present invention.
[Figure 2] Figure 2 is a vertical cross sectional view of a wafer storage case having a wafer holding member, which is a member installed in the wafer storage case according to the present invention.
[Figure 3] Figure 3 is a graph showing the measurement results of holding force of the wafer holding member of the present invention.
[Figure 4] Figure 4 is a graph showing the measurement results of vertical displacement magnitude of the wafer holding member of the present invention with time.
[Figure 5] Figure 5 is a graph showing the correlation between the PL intensity and the sulfur gas concentration on the surface of the wafer.

### Reference Numerals

1 wafer holding member
11 fixing hole 12 center connecting portion 13 leg portions
2 wafer storage case
21 case main body
21a small diameter cylindrical portion 21b large diameter cylindrical portion
21c partition 21d projection
22 lid
22a cylindrical portion 22b covering portion
22c projection 22d ring-shaped protrusion
3 wafer

### Best Mode for Carrying Out the Invention

Embodiments of the member installed in the wafer storage case of the present invention will now be described. An example in which the member installed in the wafer storage case is applied to a wafer holding member is described below.

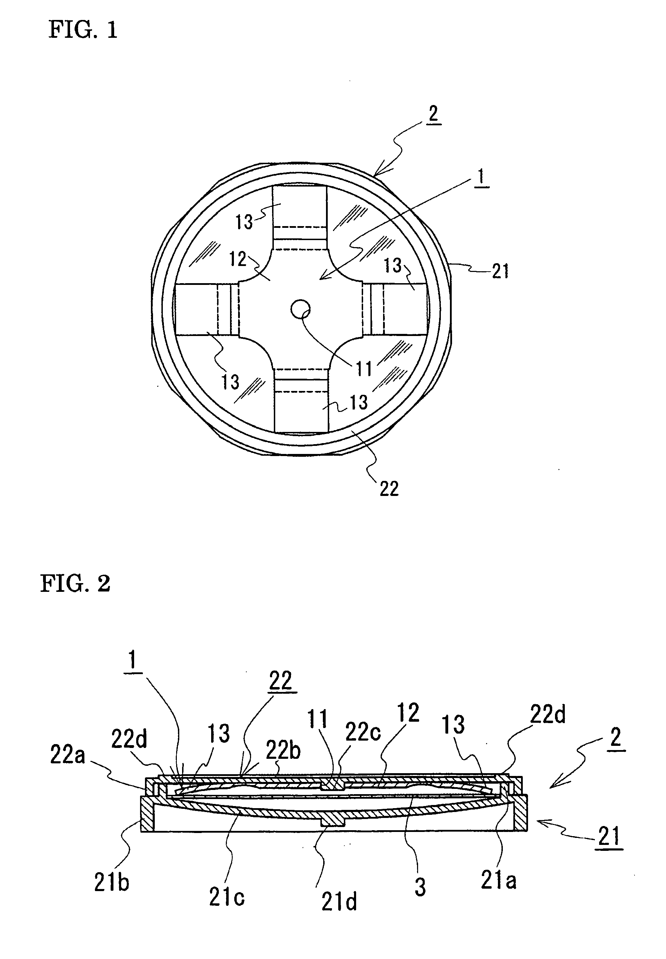

The wafer holding member is formed into a cross shape by injection molding of a polybutylene terephthalate (PBT) resin having a weight-average molecular weight (Mw) of 15000 or more and 20000 or less. This wafer holding member 1 is stored in a wafer storage case 2, as shown in Figs. 1 and 2.

The wafer storage case 2 is formed by injection molding of a transparent polycarbonate resin. The wafer storage case 2 includes a bottomed cylindrical case main body 21 and a lid 22 that covers an upper opening of the case main body 21. The material of the wafer storage case 2 is not limited to polycarbonate, and other thermoplastic resins such as polypropylene, polyethylene, etc., and thermosetting resins such as epoxy resins, phenol resins, etc., may be used.

As shown in Figs. 1 and 2, the case main body 21 has a small diameter cylindrical portion 21a at the upper side and a large diameter cylindrical portion 21b at the lower side continuing from the small diameter cylindrical portion 21a. A partition 21c that partitions the small diameter cylindrical portion 21a from the large diameter cylindrical portion 21b is provided at a position where a step portion between the small diameter cylindrical portion 21a and the large diameter cylindrical portion 21b is formed. The partition 21c has a central portion recessed and spherically curved downward. A cylindrical projection 21d is formed on the center portion of the lower surface of the partition 21c.

The lid 22 has a cylindrical portion 22a having an inner diameter larger than the outer diameter of the small diameter cylindrical portion 21a of the case main body 21 and a covering portion 22b covering one end of the cylindrical portion. The depth of the cylindrical portion 22a is the same as the height of the small diameter cylindrical portion 21a of the case main body. A projection 22c having the same size as the projection 21d formed on the partition 21c of the case main body is formed on the central portion of the lower surface of the covering portion 22b, i.e., the surface opposing the case main body 21. The projection 21d and 22c are arranged to fit into a fixing hole 11 provided in the wafer holding member 1.

Moreover, a ring-shaped protrusion 22d is formed at the upper surface side of the covering portion 22b of the lid 22 so as to be located at the same position as the end surface of the small diameter cylindrical portion 21a when the lid 22 is fitted to the small diameter cylindrical portion 21a of the case main body 21.

The wafer holding member 1 has a cross shape in a plan view and includes a center connecting portion 12, in which the fixing hole 11 is formed at the center position, and four leg portions 13 respectively extending in four directions from the center connecting portion 12.

The wafer holding member 1 is configured such that only the end portions of the leg portions 13 contact the flat component and that the center connecting portion 12 remains floating. As the center connecting portion 12 of the wafer holding member 1 is pressed downward to elastically deform the wafer holding member 1, the holding force works in the end portions of the leg portions 13.

The fixing hole 11 formed in the center connecting portion 12 of the wafer holding member 1 is fitted to the projection 22c of the lid 22 so that the wafer holding member 1 can be fixed to the lid 22 without displacement.

In storing a wafer 3 in the wafer storage case 2, the wafer 3 is first placed on the partition 21c of the case main body 21. At this stage, the partition 21c is recessed downward and only the peripheral portion of the wafer 3 is in contact with the partition 21c.

The lid 22 with the wafer holding member 1 is then fitted to the case main body 21. As the lid 22 is fitted to the case main body 21, the wafer holding member 1 is pressed with the lid 22 toward the partition 21c of the case main body 21 so that the end portions of the leg portions 13 of the wafer holding member 1 abut against the peripheral portion of the wafer 3. As a result the wafer holding member 1 fixes and immobilizes the wafer 3.

The wafer holding member 1 installed in the wafer storage case 2 is made as follows.

A polybutylene terephthalate (PBT) resin having a weight-average molecular weight (Mw) of 15000 to 20000 is used as the resin constituting the wafer holding member 1. The PBT resin is injection molded at a molding temperature of 230°C to 265°C without adding any sulfur-containing secondary antioxidant. Alternatively, if a sulfur-containing secondary antioxidant is to be added to the PBT resin, the sulfur-containing secondary antioxidant is added so that the sulfur content in the sulfur-containing secondary antioxidant is 0.1% or less of the weight of the PBT resin. Then the resulting mixture is injection molded at a molding temperature of 230°C to 265°C so as to make the wafer holding member 1 shown in Figs. 1 and 2.

Injection molding is conducted by controlling the mold temperature in the range of 40°C to 80°C, the rotation speed of the screw of the injection molding machine in the range of 40 rpm to 200 rpm, the injection pressure in the range of 200 kg/cm² to 1500 kg/cm², and the back pressure in the range of 0 kg/cm² to 100 kg/cm².

Additive agents other than the sulfur-containing secondary oxidant may be added to the polybutylene terephthalate (PBT) resin. Examples thereof include a primary antioxidant, a light stabilizer, and a hydrolytic inhibitor.

### (Examples)

Table II below shows measurement results of the variation in dimensional accuracy (rating is given as "small" or "large") and the holding force (rating is given as "good" or "poor") of molded articles when the molded articles, i.e., the wafer holding members, shown in Fig. 1 were formed by injection molding of PBT resins having different weight-average molecular weights (Mw) and number-average molecular weights (Mn). Note that the injection molding process was conducted without adding the sulfur-containing secondary antioxidant.

The injection conditions during the injection molding were a molding temperature of 250°C, a mold temperature of 60°C, a speed of rotation of a screw of an injection molding machine of 100 rpm, an injection pressure of 1000 kg/cm², and a back pressure of 100 kg/cm².

**[Table II]**

| Sample No. | Weight-average molecular weight (Mw) | Number-average molecular weight (Mn) | Mw/Mn | Variation in dimensional accuracy of molded articles | Holding force |
|---|---|---|---|---|---|
| Sample No. 1 | 16600 | 7500 | 2.2 | Small | Good |
| Sample No. 2 | 16800 | 8000 | 2.1 | Small | Good |
| Sample No. 3 | 17500 | 7300 | 2.2 | Small | Good |
| Sample No. 4 | 17500 | 8000 | 2. 2 | Small | Good |
| Sample No. 5 | 18900 | 7500 | 2.5 | Small | Good |
| Sample No. 6 | 19600 | 8400 | 2.3 | Small | Good |
| Sample No. 7 | 19800 | 8800 | 2.3 3 | Small | Good |
| Sample No. 8 | 23700 | 10600 | 2.2 | Large | Poor |
| Sample No. 9 | 28200 | 11000 | 2.6 | Large | Poor |
| Sample No. 10 | 33000 | 11100 | 3 | Large | Poor |
| Sample No. 11 | 35900 | 13200 | 2.7 | Large | Poor |

As shown in Table II, the variation in dimension was small and the holding force was good in Samples 1 to 7 in which a PBT resin having a weight-average molecular weight (Mw) of 15000 to 20000 was used.

The wafer holding force and the vertical displacement magnitude of the wafer holding member with time were compared between holding members (Samples 2-1 and 2-2) prepared by injection molding the PBT resin (without addition of sulfur-containing secondary antioxidant) of Sample 2 in Table II and holding members (Samples 2-3 and 2-4) prepared by injection molding a mixture of the PBT resin and a sulfur-containing secondary antioxidant, the sulfur content therein being 1% on a weight basis.

No sulfur gas was generated from Samples 2-1 and 2-2 and the PL intensity of the wafers stored in these samples was 70 whereas the sulfur gas concentration at the surfaces of the wafers held in Samples 2-3 and 2-4 was 500 (×E10 atoms/cm²) and the PL intensity was 20.

The wafer holding force was determined by the vertical displacement magnitude of the wafer holding member relative to the load applied to the wafer holding member.

The vertical displacement magnitude of the wafer holding member with time was determined by measuring the height of the holding member before storing the wafer in the case and then the height of the holding member 2 hours, 4 hours, 8 hours, and 16 hours after the wafer was stored in the case. The difference between the initial value and the observed values after these hours was calculated to determine the displacement magnitude. The vertical displacement magnitude of the wafer holding member with time is an indicator for evaluating the change in holding force with time.

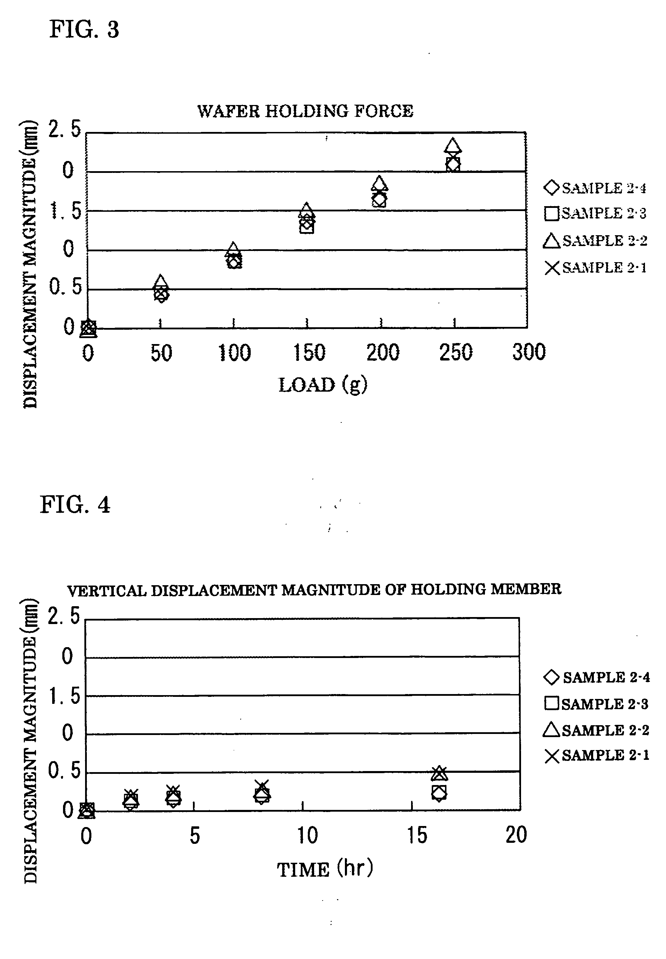

The measurement results of the wafer holding force are shown in Fig. 3, and the measurement results of the vertical displacement magnitude of the wafer holding member with time are shown in Fig. 4.

As for the wafer holding force and the vertical displacement magnitude of the wafer holding member with time, the results of the samples free of a sulfur-containing secondary antioxidant were substantially the same as the samples in which a sulfur-containing secondary antioxidant was added.

It should be understood that the present invention is not limited to the embodiment and examples described above and covers all modifications and alternations within the scope of the claims and equivalents thereof. For example, the present invention may be applied to a holding member for a storage case capable of storing a plurality of wafers instead of a wafer holding member for a storage case capable of storing wafer one by one described above. Moreover, the present invention may be applied to a sealing member for each storage case.

### Industrial Applicability

A member installed in a wafer storage case of the present invention and a method for producing the member are particularly suitable for use in a case for storing a silicone wafer.

## Claims

1. A member installed in a case for storing a wafer, **characterized in that:**
the member in the case is formed by injection molding of a polybutylene terephthalate (PBT) resin;
a weight-average molecular weight (Mw) of the PBT resin is 15000 to 20000; and
a weight of sulfur in a sulfur-containing secondary antioxidant added to the PBT resin is 0.1% or less of the weight of the PBT resin.

2. The member installed in the case for storing the wafer according to claim 1, **characterized in that:**
the member installed in the case for storing the wafer is a wafer holding member.

3. A method for producing a member installed in a case for storing a wafer, **characterized by** comprising:
injection-molding a polybutylene terephthalate (PBT) resin having a weight-average molecular weight (Mw) of 15000 to 20000 so that the weight of sulfur in a sulfur-containing secondary antioxidant added to the PBT resin is 0.1% or less of the weight of the PBT resin.

4. The method for producing the member installed in the case for storing the wafer according to claim 3, **characterized in that** the member installed in the case for storing the wafer is injection molded at a molding temperature of 230°C to 265°C.

5. The method for producing the member installed in the case for storing the wafer according to claim 3 or 4, **characterized in that** the member installed in the case for storing the wafer is a wafer holding member.
